# EUROPEAN PATENT SPECIFICATION

(11) **EP 2 425 693 B1**
(45) Date of publication and mention of the grant of the patent: **21.10.2015**
(21) Application number: 10769302.0
(22) Date of filing: 26.04.2010
(51) Int. Cl.: H05K 5/06, H05K 5/00

(54) **SHELL ASSEMBLING DEVICE AND SHELL HAVING THE SAME**
GEHÄUSEMONTAGEVORRICHTUNG UND GEHÄUSE DAMIT
DISPOSITIF DE MONTAGE D'ENVELOPPE ET ENVELOPPE COMPORTANT CELUI-CI

(30) Priority: 30.04.2009 CN 200920131262 U
(43) Date of publication of application: 07.03.2012
(73) Proprietor: BYD Company Limited, Shenzhen, Guangdong 518118 (CN)
(72) Inventor: WANG, Guangcheng, Guangdong 518118 (CN)
(74) Representative: Gulde & Partner
(86) International application number: PCT/CN2010/072217
(87) International publication number: WO 2010/124613

(56) References cited:
- CN-A- 1 825 665
- CN-Y- 2 750 622
- CN-Y- 2 874 594
- US-A1- 2004 174 665
- US-A1- 2007 149 030
- US-A1- 2008 020 813
- US-A1- 2010 128 429
- US-B1- 7 208 686

## Description

The present invention generally relates to a shell assembling device and a shell having the assembling device. Such a device is disclosed by the document US 7 208686, HON HAI PREC IND Co LTD, published on 24 April 2007.

### BACKGROUND

With the large-scale popularization of all kinds of electric products, the requirements for the appearance of the electronic products become higher. Particularly, the concept of seamless connection has become an important reference for the appearance quality of the electronic products. On one hand, it is advantageous to reduce assembly clearance of the electronic product shells so as to prevent dust from entering into electronic products; on the other hand, smaller clearance means that the electronic products seem fine and high quality for consumers, so that the assembly clearance of the shell of the electronic products becomes an important factor for consumers to select electronic products.

However, because of existence of the tolerance, clearance of the shell is inevitable. Especially, in production process, more severe control of the tolerance means higher cost. Therefore it's necessary to provide a shell assembling device that may reduce the clearance of the shell and be economical.

### SUMMARY OF THE INVENTION

The present invention is directed to solve at least one of the problems in the prior art.

Accordingly, the present invention provides a shell assembling device that may reduce assembly clearance.

The shell assembling device for assembling a shell having a first cover and a second cover according to the present invention, comprising: a rigid fitting structure provided on the first cover and second cover, and an elastic interference fitting structure provided on the first cover and second cover, which is used to assemble a first cover and a second cover.

The present invention further provides a shell comprising a first cover; a second cover; and an assembling device provided on the first and second covers and used for fitting the first cover and second cover, in which the assembling device is the assembling device mentioned above.

By using the elastic interference fitting structure and the rigid fitting structure simultaneously to assemble the shell, the disadvantageous effects of tolerance may be eliminated, and the assembly clearance between the first cover and the second cover may be reduced.

Further aspects of the invention could be learned from the description and the claims.

### BRIEF DESCRIPTION OF THE DRAWINGS

Fig. 1 is a perspective view of a shell according to an embodiment of the present invention.
Fig. 2 is a front view of the shell in Fig. 1.
Fig. 3 is a section view taking along line A-A in Fig. 2.
Fig. 4 is a section view taking along line B-B in Fig. 2.
Fig. 5 is an exploded perspective view of the shell in Fig. 1.
Fig. 6 is a perspective view of the second cover of the shell in Fig. 1.
Fig. 7 is a front view of the shell according to another embodiment of the present invention.
Fig. 8 is a section view taking along line A-A in Fig. 7.
Fig. 9 is a section view taking along line B-B in Fig. 7.
Fig. 10 is an exploded perspective view of the shell in Fig.7.
Fig. 11 is a perspective view of the second cover of the shell in Fig. 7.

### DETAILED DESCRIPTION OF THE EMBODIMENTS OF THE INVENTION

These and other aspects, solutions and advantages of the invention will become apparent and more readily appreciated from the following descriptions taken in conjunction with the drawings.

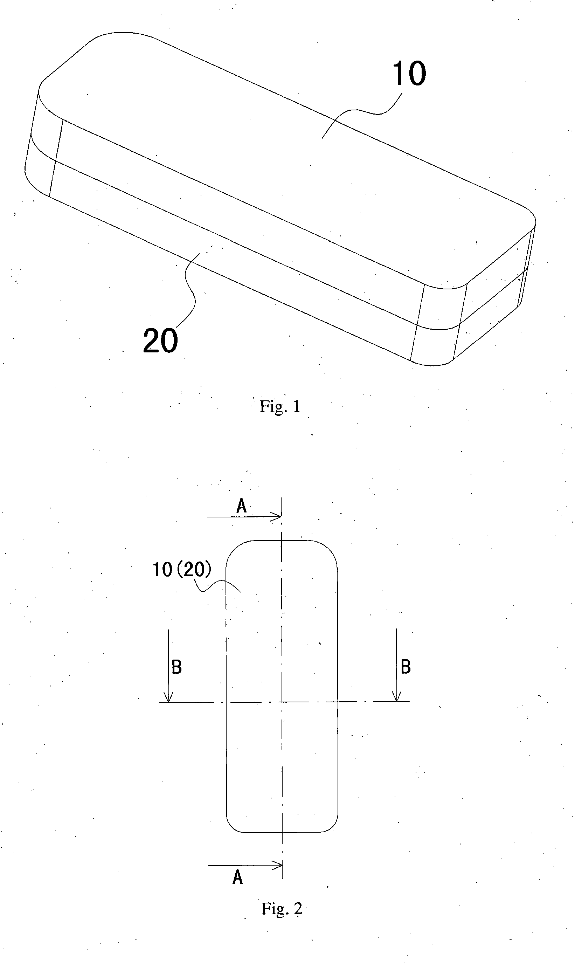

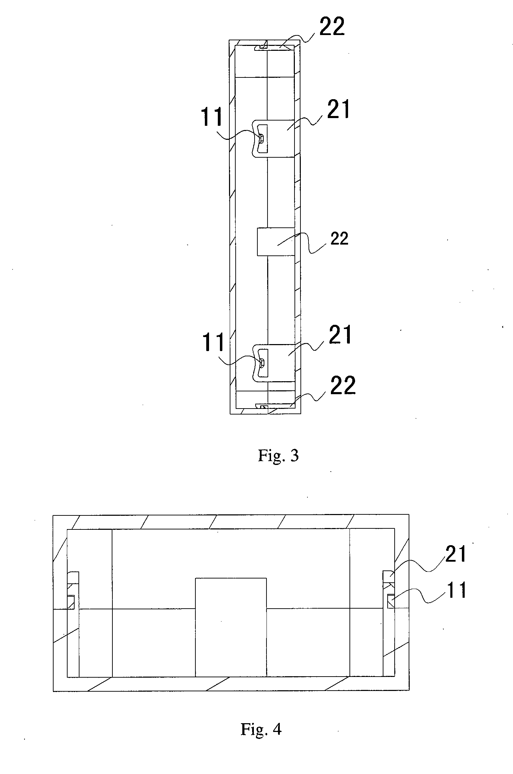

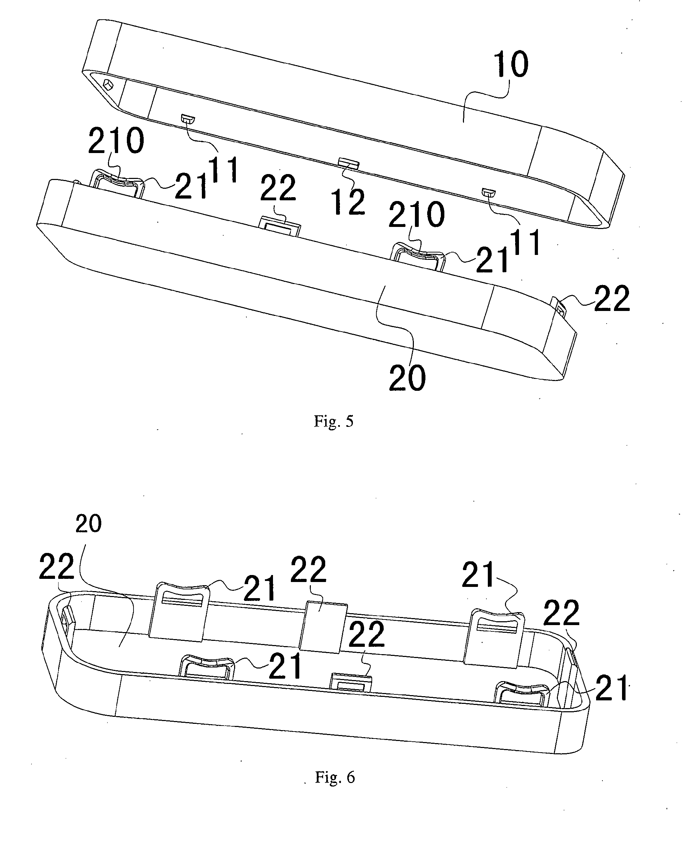

In Fig. 1 to Fig. 6, the shell assembling device according to a first embodiment of the invention is shown. The shell assembling device is used to assemble the first cover 10 and the second cover 20 so as to form a shell. The shell assembling device comprises a rigid fitting structure mounted on the first cover 10 and second cover 20, and an elastic interference fitting structure mounted on the first cover 10 and second cover 20.

In some embodiments, the rigid fitting structure is a rigid snap-in fitting structure and comprises a rigid female button 22 disposed on the second cover 20 and a male boss 12 disposed on the first cover 10 and adapted snap in the rigid female button 22. During assembling of the shell, the male boss 12 may be clipped in the rigid female button 22 and can't move therein.

In other embodiments, the rigid fitting structure may be screw or other rigid fitting structures.

The elastic interference fitting structure is of a snap-in type and comprises an elastic female button 21 mounted on the second cover 20, the elastic female button 21 has an elastic arm 210, and a male tongue 11 mounted on the first cover 10 and adapted to snap in the elastic female button 21. After the first cover 10 is assembled with the second cover 20 to form the shell, the male tongue 11 may be clipped in the elastic female button 21 with interference fitting therebetween. The elastic arm 210 deforms to impose an elastic force on the male tongue 11, so that the fitting between the first cover 10 and the second cover 20 is tight and the assembly clearance between the first and second covers may be reduced. The shell assembling device may solve the problems caused by only using rigid fitting structure via the elastic interference fitting structure, and it is more economical. Because of existence of rigid fitting structure, it is difficult for users to feel that there is provided an elastic interference fitting structure between the first and second covers. In some embodiments, the male tongue 11 and the male boss 12 are provided alternatively on the first cover 10, and accordingly the elastic female button 21 and the rigid female button 22 are provided alternatively on the second cover 20.

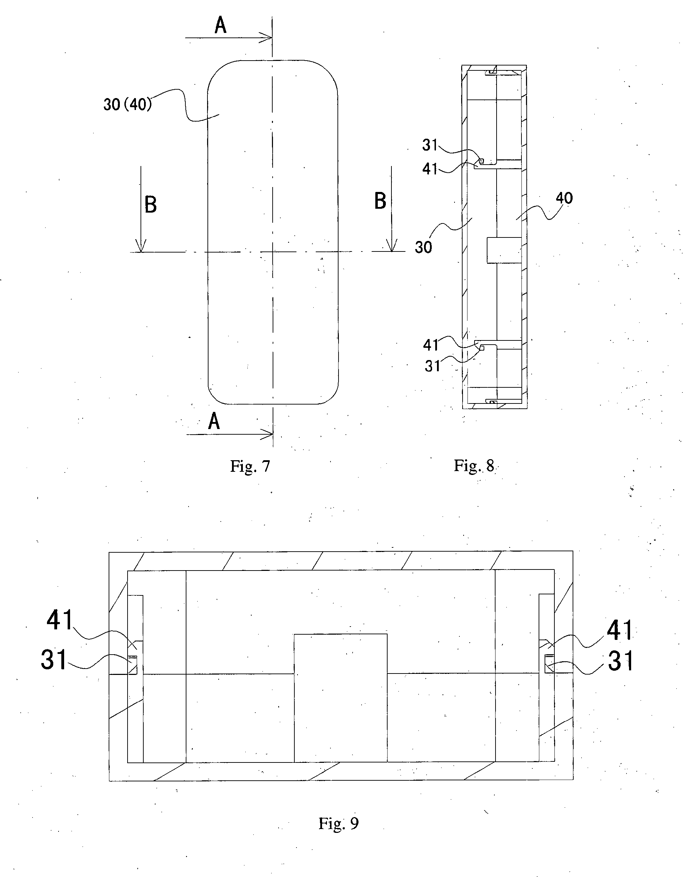

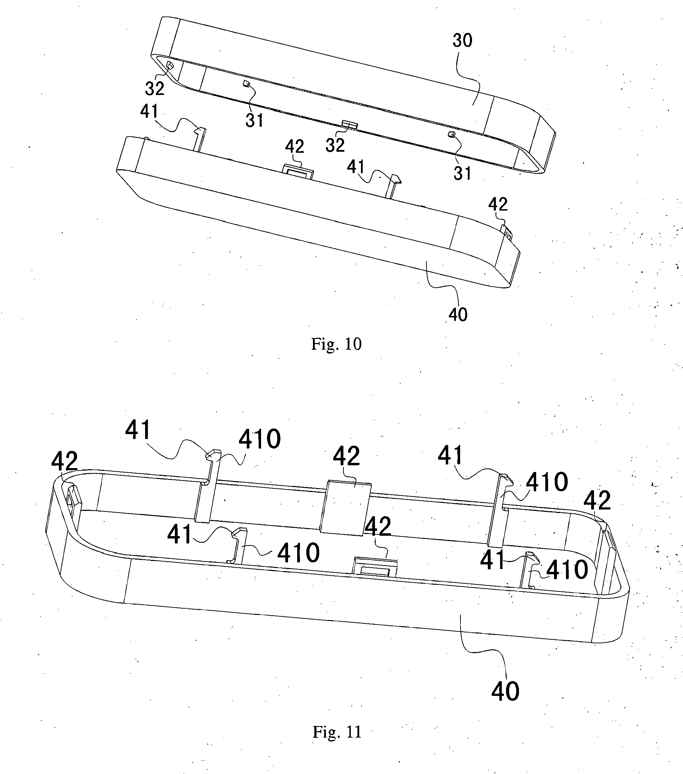

Referring to Fig. 7 to Fig. 11, the shell assembling device according to a second embodiment of the invention is shown. According to the second embodiment, the rigid fitting structure comprises a rigid female button 42 disposed on the second cover 40 and a male boss 32 disposed on the first cover 30. During assembling of the shell, the male boss 32 may be clipped in the rigid female button 42 and can't move therein. The elastic interference fitting structure comprises a male tongue 31 disposed on the first cover 30 and an elastic hook 41 disposed on the second cover 20. During assembling of the shell, the male boss 31 may be caught by the elastic hook 41 with interference fitting therebetween. After assembling, the elastic connecting arm 410 imposes an elastic force on the male boss 31, so that the fitting between the first cover 30 and the second cover 40 is tight and the assembly clearance between the two covers may be eliminated. The shell assembling device may solve the problems caused by only using rigid fitting structures via the elastic interference fitting structure, and it is more economical. Because of the existence of the rigid fitting structure, it is difficult for users to feel that there is provided an elastic interference fitting structure between the first and second covers.

As shown in Fig. 1 to Fig. 11, a shell according to an embodiment is provided, which comprises a first cover, a second cover, and an assembling device provided on the first and second covers and used for fitting the first cover and second cover. The assembling device may be any one described in the above two embodiments. The elastic interference fitting structure may solve the clearance problems caused by only using the rigid fitting structure due to the tolerance, and it is more economical. Because of the existence of the rigid fitting structure, it is difficult for users to feel that there is provided an elastic interference fitting structure between the first and second covers.

## Claims

1. A shell assembling device for assembling a shell having a first cover (10, 30) and a second cover (20, 40), the shell assembling device comprising: a rigid fitting structure (12, 22; 32, 42) provided on the first cover (10, 30) and second cover (20, 40), and an elastic fitting structure (11, 21; 32, 41) provided on the first cover (10, 30) and second cover (20, 40), **characterized in that**
the rigid fitting structure (12, 22; 32, 42) is configured to hold the first cover (10, 30) and the second cover (20, 40) together,
and the elastic fitting structure (11, 21; 32, 41) is an elastic interference fitting structure (11, 21; 32, 41), configured to provide an elastic force to the two covers (10, 30; 20, 40), such that an assembly clearance between the two covers (10, 30; 20, 40) is reduced or eliminated.

2. The shell assembling device of claim 1, wherein the rigid fitting structure (12, 22; 32, 42) and the elastic interference fitting structure (11, 21; 32, 41) are provided alternatively.

3. The shell assembling device of claim 1, wherein the elastic interference fitting structure (11, 21; 32, 41) is of a snap-in type and comprises an elastic female button (21) mounted on one of the first and second covers, and a male tongue (11) mounted on the other of the first and second covers and interference-fit with the elastic female button (21).

4. The shell assembling device of claim 1, wherein the elastic interference fitting structure (11, 21; 32, 41) is of a snap-in type and comprises an elastic hook (41) mounted on one of the first and second covers, and a male tongue (31) mounted on the other of the first and second covers and adapted to interference-fit with the elastic hook (41).

5. The shell assembling device of any one of claims 1, wherein the rigid fitting structure (12, 22; 32, 42) is a rigid snap-in fitting structure.

6. The shell assembling device of any one of claims 1-5, wherein the rigid fitting structure (12, 22; 32, 42) is a screw.

7. A shell, comprising:
a first cover (10, 30);
a second cover (20, 40); and
an assembling device provided on the first and second covers and used for fitting the first cover and second cover,
wherein the assembling device is the assembling device of claim 1.

## Patentansprüche

1. Schalenmontagevonichtung zum Montieren einer Schale mit einer ersten Abdeckung (10, 30) und einer zweiten Abdeckung (20, 40), wobei die Schalenmontagevorrichtung Folgendes umfasst: eine an der ersten Abdeckung (10, 30) und zweiten Abdeckung (20, 40) bereitgestellte starre Passstruktur (12, 22; 32, 42), und an auf der ersten Abdeckung (10, 30) und zweiten Abdeckung (20, 40) bereitgestellte elastische Passstruktur (11, 21; 32, 41), **dadurch gekennzeichnet, dass**
die starre Passstruktur (12, 22; 32, 42) gestaltet ist, die erste Abdeckung (10, 30) und die zweite Abdeckung (20, 40) zusammenzuhalten,
und die elastische Passstruktur (11, 21; 32, 41) eine elastische Presspassstruktur (11, 21; 32, 41) ist, die gestaltet ist, eine elastische Kraft für die beiden Abdeckungen (10, 30; 20, 40) bereitzustellen, sodass ein Montagespiel zwischen den beiden Abdeckungen (10, 30; 20, 40) verringert oder beseitigt wird.

2. Schalenmontagevorrichtung nach Anspruch 1, wobei die starre Passstruktur (12, 22; 32, 42) und die elastische Presspassstruktur (11, 21; 32, 41) alternativ bereitgestellt sind.

3. Schalenmontagevorrichtung nach Anspruch 1, wobei die elastische Presspassstruktur (11, 21; 32, 41) von einem Einschnapp-Typ ist und einen elastischen weiblichen Knopf (21), der an der ersten oder zweiten Abdeckung montiert ist, sowie eine männliche Zunge (11), die an der anderen ersten bzw. zweiten Abdeckung montiert und geeignet ist, eine Presspassung mit dem elastischen weiblichen Knopf (21) einzugehen, umfasst.

4. Schalenmontagevorrichtung nach Anspruch 1, wobei die elastische Presspassstruktur (11, 21; 32, 41) von einem Einschnapp-Typ ist und einen elastischen Haken, der an der ersten oder zweiten Abdeckung montiert ist, sowie eine männliche Zunge (31), die an der anderen ersten bzw. zweiten Abdeckung montiert und geeignet ist, eine Presspassung mit dem elastischen Haken (41) einzugehen, umfasst.

5. Schalenmontagevorrichtung nach einem der Ansprüche 1, wobei die starre Passstruktur (12, 22; 32, 42) eine starre Einschnapp-Passstruktur ist.

6. Schalenmontagevorrichtung nach einem der Ansprüche 1 - 5, wobei die starre Passstruktur (12, 22; 32, 42) eine Schraube ist.

7. Schale, umfassend:
eine erste Abdeckung (10, 30);
eine zweite Abdeckung (20, 40); und
eine auf der ersten und der zweiten Abdeckung bereitgestellte Montagevorrichtung, die zur Anbringung der ersten Abdeckung und der zweiten Abdeckung genutzt wird, wobei die Montagevorrichtung die Montagevorrichtung nach Anspruch 1 ist.

## Revendications

1. Dispositif d'assemblage d'enveloppe pour assembler une enveloppe ayant un premier couvercle (10, 30) et un deuxième couvercle (20, 40), le dispositif d'assemblage d'enveloppe comprenant : une structure d'adaptation rigide (12, 22 ; 32, 42) disposée sur le premier couvercle (10, 30) et le deuxième couvercle (20, 40), et une structure d'adaptation élastique (11, 21 ; 32, 41) disposée sur le premier couvercle (10, 30) et le deuxième couvercle (20, 40), **caractérisé en ce que**
la structure d'adaptation rigide (12, 22 ; 32, 42) est configurée pour retenir ensemble le premier couvercle (10, 30) et le deuxième couvercle (20, 40),
et la structure d'adaptation élastique (11, 21 ; 32, 41) est une structure d'adaptation à serrage élastique (11, 21 ; 32, 41) configurée pour fournir une force élastique au deux couvercles (10, 30 ; 20, 40) de telle sorte qu'un jeu d'assemblage entre les deux couvercles (10, 30 ; 20, 40) est réduit ou éliminé.

2. Dispositif d'assemblage d'enveloppe selon la revendication 1, dans lequel la structure d'adaptation rigide (12, 22 ; 32, 42) et la structure d'adaptation à serrage élastique (11, 21 ; 32, 41) sont disposées de façon alternée.

3. Dispositif d'assemblage d'enveloppe selon la revendication 1, dans lequel la structure d'adaptation à serrage élastique (11, 21 ; 32, 41) est du type à encliquetage et comprend un bouton femelle élastique (21) monté sur l'un des premier et deuxième couvercles, et une languette mâle (11) montée sur l'autre des premier et deuxième couvercles et adaptée par serrage au bouton femelle élastique (21).

4. Dispositif d'assemblage d'enveloppe selon la revendication 1, dans lequel la structure d'adaptation à serrage élastique (11, 21 ; 32, 41) est du type à encliquetage et comprend un crochet élastique (41) monté sur l'un des premier et deuxième couvercles, et une languette mâle (31) montée sur l'autre des premier et deuxième couvercles et adaptée pour une adaptation à serrage avec le crochet élastique (41).

5. Dispositif d'assemblage d'enveloppe selon l'une quelconque des revendications 1, dans lequel la structure d'adaptation rigide (12, 22 ; 32, 42) est une structure d'adaptation par encliquetage rigide.

6. Dispositif d'assemblage d'enveloppe selon l'une quelconque des revendications 1 à 5, dans lequel la structure d'adaptation rigide (12, 22 ; 32, 42) est une vis.

7. Enveloppe, comprenant :
un premier couvercle (10, 30) ;
un deuxième couvercle (20, 40) ; et
un dispositif d'assemblage disposé sur les premier et deuxième couvercles et utilisé pour l'adaptation du premier couvercle et du deuxième couvercle,
dans laquelle le dispositif d'assemblage est le dispositif d'assemblage de la revendication 1.
